**Europäisches Patentamt**

**European Patent Office**

**Office européen des brevets**

(19)

(11) Veröffentlichungsnummer: **0 096 651**
**B1**

(12) **EUROPÄISCHE PATENTSCHRIFT**

(45) Veröffentlichungstag der Patentschrift:
**13.11.85**

(21) Anmeldenummer: **83710030.4**

(22) Anmeldetag: **24.05.83**

(51) Int. Cl.⁴: **H 02 H 3/087,** H 01 L 27/02

(54) Zweipoliger Überstromschutz.

(30) Priorität: **03.06.82 SE 8203432**

(43) Veröffentlichungstag der Anmeldung:
**21.12.83 Patentblatt 83/51**

(45) Bekanntmachung des Hinweises auf die Patenterteilung:
**13.11.85 Patentblatt 85/46**

(84) Benannte Vertragsstaaten:
**DE FR GB IT NL**

(56) Entgegenhaltungen:
**GB - A - 2 049 316**
**US - A - 3 798 514**

(73) Patentinhaber: **ASEA AB, S-721 83 Västeras (SE)**

(72) Erfinder: **Svedberg, Per, Björnskogsgränd 13,**
**S-162 46 Vällingby (SE)**

(74) Vertreter: **Boecker, Joachim, Dr.-Ing.,**
**Rathenauplatz 2-8, D-6000 Frankfurt a.M. 1 (DE)**

BUNDESDRUCKEREI BERLIN

## Beschreibung

Die Erfindung betrifft einen zweipoligen Überstromschutz gemäß dem Oberbegriff des Anspruches 1. Ein solcher Überstromschutz ist bekannt aus der GB-A-2 049 316.

Bei dem bekannten Überstromschutz sind zum Schutz der Steuereingänge der Feldeffekttransistorteile gegen Überspannungen Zenerdioden vorgesehen. Diese Zenerdioden sind in demselben integrierten Schaltkreis wie die übrigen Bauteile des Überstromschutzes enthalten. Wenn beide Thyristorteile des Überstromschutzes stromführend sind, dann führen die dabei erzeugten Ladungsträger zu großen Leckströmen über die Zenerdioden, wodurch die Funktion des Überstromschutzes nachteilig beeinflußt wird.

Der Erfindung liegt die Aufgabe zugrunde, einen Überstromschutz der vorgenannten Art zu entwickeln, bei dem ein wirksamer Überspannungsschutz der Steuereingänge der Feldeffekttransistoren erreicht wird, ohne daß die vorgenannten unerwünschten Erscheinungen auftreten.

Zur Lösung dieser Aufgabe wird ein Überstromschutz nach dem Oberbegriff des Anspruches 1 vorgeschlagen, der erfindungsgemäß die im kennzeichnenden Teil des Anspruches 1 genannten Merkmale hat.

Ausgestaltungen der Erfindung sind in den weiteren Ansprüchen genannt.

Anhand des in den Figuren dargestellten Ausführungsbeispieles soll die Erfindung näher erläutert werden. Es zeigt

Fig. 1 einen Schnitt durch ein Ausführungsbeispiel einer Halbleiterstruktur, die in integrierter Form einen Überstromschutz gemäß der Erfindung enthält,

Fig. 2 das dem Überstromschutz gemäß Figur 1 entsprechende äquivalente Schaltbild.

Wie in der obengenannten englischen Patentanmeldung beschrieben, ist der Überstromschutz in eine Siliziumscheibe 1a mit einem N-dotierten (N-leitenden) Hauptschicht 1 integriert, welches die N-Basis sowohl für die Thyristoren wie für den Transistorteil bildet. Zentral auf der oberen Seite der Scheibe ist eine P-dotierte Schicht 12 und in dieser eine P+-dotierte Schicht 11 angeordnet. Um diese Schichten herum liegt eine P-dotierte, ringförmige Schicht 14, die eine N+-dotierte, ringförmige Schicht 13 einschließt. An der unteren Seite der Scheibe sind die Schichten 21 bis 24 in gleicher Weise angeordnet wie die Schichten 11 bis 14 an der oberen Seite der Scheibe. Die Schichten 11 und 13 sind mit der Anschlußklemme A verbunden, während die Schichten 21 und 23 mit der Anschlußklemme B verbunden sind.

Eine »P+-dotierte« (P+-leitende) Schicht ist eine Schicht mit stärkerer Dotierung als eine »P-dotierte« (P-leitende) Schicht; dasselbe gilt für eine »N+-dotierte« im Verhältnis zu einer »N-dotierten« Schicht.

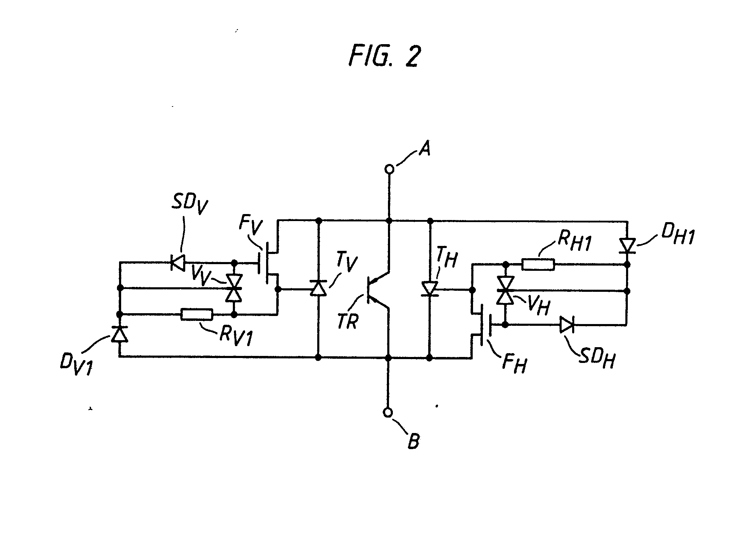

Der Thyristor $T_H$ (siehe Figur 2) ist aus den Schichten 11, 12, 1, 24 und 23 aufgebaut. Wenn der Thyristor leitet, fließt der Strom in seitlicher Richtung durch die Schicht 1 von der Schicht 12 zur Schicht 24. Dieser Strom besteht im wesentlichen aus von der Schicht 12 in die Schicht 1 injizierten Minoritätsladungsträgern, d. h. Löchern.

Der Transistorteil TR (siehe Figur 2) besteht aus den Schichten 11, 12, 1, 22, 21; er ist also vom PNP-Typ. Bei niedrigem Strom durch den Thyristor $T_H$ ist der untere PN-Übergang (zwischen den Schichten 22 und 1) des Transistorteils nicht sperrend oder schwach injizierend. Keine, oder nur einige, der von der Schicht 12 in die Schicht 1 injizierten Löcher werden dabei über den Übergang abgesaugt. Wenn der Strom durch den Thyristor zunimmt, wird der Durchlaßspannungsfall des Thyristors größer, und als Folge der zunehmenden Spannung tritt am Übergang 1—22 eine steigende Sperrspannung auf, und über den Übergang wird ein größerer Teil der in die Schicht 1 injizierten Löcher abgesaugt. Die Stromverstärkung des PNP-Teils des Thyristors $T_H$ sinkt dadurch, und der Thyristor wird schlechter ausgesteuert, was eine weitere Erhöhung der Durchlaßspannung am Thyristor zur Folge haben kann. Hierdurch erhält man einen schnellen Anstieg der Thyristorspannung, wenn sich der Strom einem vorbestimmten Grenzwert nähert, der durch geeignete Wahl der Lebensdauer der Ladungsträger in der Schicht 1 im Verhältnis zu dem Innenradius der peripheren P-Schicht 14 und zu der Dicke der N-Basisschicht 1 festgelegt werden kann.

Dadurch, daß die Schicht 11 mit hoher Injektion zentral in der Scheibe 1a angeordnet ist, erhält man einen im wesentlichen sich lateral erstreckenden PNP-Transistorteil für den Thyristor $T_H$, was die vorstehend beschriebene Wirkung ergibt.

Der Thyristor $T_V$ (siehe Figur 2) besteht aus den Schichten 21, 22, 1, 14, 13 und arbeitet auf entsprechende Weise, wie es oben für den Thyristor $T_H$ beschrieben wurde.

An der oberen Seite der Scheibe sind die zum Steuerkreis des Thyristors $T_V$ gehörenden Teile angeordnet, während Steuerkreisteile des Thyristors $T_H$ an der unteren Seite der Scheibe angeordnet sind.

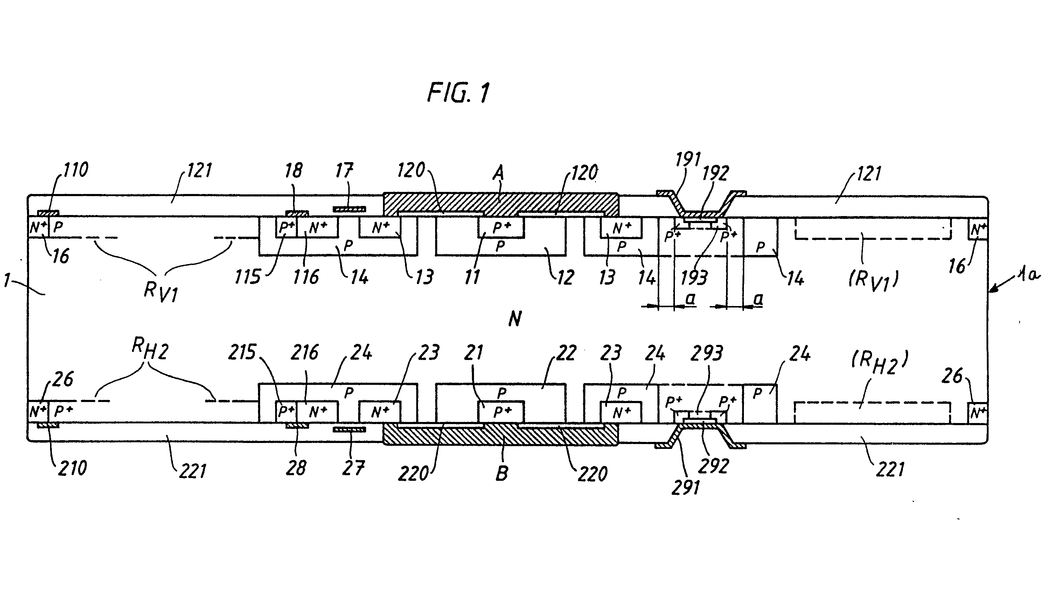

Die Schichten 13 und 14 sind ringförmig und umschließen die zentralen Schichten 11 und 12. Ein kreisförmiger Metallkontakt A hat Kontakt mit den Schichten 11 und 13 und bildet den einen Anschluß des Überstromschutzes. Der Kontakt ist gegen die Schichten 12, 1, 14 durch eine darunter liegende Siliziumdioxydschicht 120 isoliert. Radial außerhalb der Schicht 13 ist in der Schicht 14 eine N+-dotierte Schicht 116 und eine neben dieser liegende P+-dotierte Schicht 115 vorhanden. Diese beiden Schichten sind ringförmig, mit Ausnahme eines Sektors (rechts in Figur 1), in dem eine Schottky-Diode $SD_V$ angeordnet ist. Ein elektrischer Kontakt 18, beispielsweise aus Platinsilizid, überdrückt den Übergang zwischen den Schichten 115 und 116. Auf der Oberfläche ist eine isolierende Siliziumdioxydschicht 121 angebracht, und in dieser ist der Steuereingang 17 des MOS-Transistors $F_V$ in Form einer Schicht aus Metall oder Polysilizium angeordnet. Dieser Transistor besteht aus den Schichten 13, 14 und 116. Die letztere ist über den Kontakt 18 und die Schicht 115 mit der P-Basis 14 des Thyristors $T_V$ ohmsch verbunden. Wenn dieser Transistor über den Steuereingang 17 leitend gemacht wird, so wird die P-Basis 14 des Thyristors mit dem $N^+$-Emitter 13 des Thyristors über eine ohmsche Verbindung mit kleiner Impedanz verbunden. Der injizierende Emitterübergang 13—14 wird also praktisch kurzgeschlossen und der Thyristor erlischt.

Am Rand der oberen Seite der Scheibe ist eine ringförmige $N^+$-dotierte Zone 16 vorhanden. Diese Zone bildet den gemeinsamen Punkt (siehe Figur 2) für die Diode $D_{V1}$ und den Widerstand $R_{V1}$. Die Diode $D_{V1}$ besteht aus dem Anodenemitterübergang (22—1) des Thyristors $T_V$. Der Widerstand $R_{V1}$ besteht aus einer schmalen langgestreckten P-dotierten Schicht in der Oberflächenschicht der Scheibe. Links in der Figur ist das eine Ende des Widerstandes ohmsch längs einer Meander- oder Spirallinie in der Oberflächenschicht der Scheibe zwischen den Schichten 14 und 16 verlegt. Das andere Ende des Widerstandes schließt an die P-Basisschicht 14 des Thyristors an.

In einer beispielsweise kreisrunden oder quadratischen Öffnung in der Schicht 14 rechts in Figur 1 ist die Schottky-Diode $SD_V$ angeordnet. In der Öffnung reicht die N-dotierte Schicht 1 bis zur Oberfläche der Halbleiterscheibe 1a. Ein dünner Bereich 192 an der Oberfläche der Scheibe ist in Platinsilizid umgewandelt und bildet zusammen mit der Schicht 1 einen Schottky-Diodenübergang. Ein Kontakt 191 aus polykristallinem Silizium ist auf der Schicht 192 angebracht und erstreckt sich in seitlicher Richtung über die Siliziumdioxydschicht 121. Dadurch wirkt diese wie eine sog. Feldplatte und verhindert Feldkonzentrationen an den Ecken der darunterliegenden Schichten. Der Kontakt 191 ist über eine nicht gezeigte Verbindung an den Steuereingang 17 des Feldeffekttransistors $F_V$ angeschlossen.

Der Kontakt 191 kann alternativ aus Metall bestehen.

Die Schottky-Diode, die eine niedrige Injektion und einen verhältnismäßig hohen Leckstrom hat, ersetzt die Dioden $D_{V3}$ und $D_{V2}$ in der obengenannten englischen Patentschrift.

Bei steigender Spannung am Thyristor $T_V$ breitet sich die Sperrschicht am Übergang zwischen den Schichten 1 und 14 in seitlicher Richtung aus. Wenn die Spannung so weit angestiegen ist, daß sich die Sperrschicht bis zum Rand der Schottky-Diode ausgedehnt hat, verursacht ein weiterer Anstieg der Thyristorspannung keine Erhöhung der Spannung des MOS-Steuereingangs 17 relativ zu der Schicht 14. Die Spannung des MOS-Steuereingangs wird also automatisch begrenzt, ohne daß eine separate Schutzdiode erforderlich ist.

Der laterale Abstand zwischen der Schicht 192 und dem Rand der sie umgebenden Schicht 14 wird so bemessen, daß die Spannung, bei welcher die Sperrschicht zwischen den Schichten 1 und 14 den Rand der Schottky-Diode erreicht, kleiner als die Durchbruchsspannung des MOS-Steuereingangs 17 ist. Der Abstand kann beispielsweise 10 bis 20 μm sein, und die Spannung, bei welcher die vorgenannte Sperrschicht den Rand der Schottky-Diode erreicht, d. h., das Schutzniveau kann beispielsweise 20 bis 30 V betragen.

Bei der Ausführungsform nach Fig. 1 ist eine ringförmige Schicht 193 aus $P^+$-dotiertem Material am Rand der Schottky-Diode angeordnet. Diese Schicht ist nicht notwendig; sie bewirkt jedoch ein gleichmäßigeres Feldbild und trägt dazu bei, daß Feldkonzentrationen an der Ecke des Kontaktes 191 vermieden werden. Das Schutzniveau liegt dann bei der Spannung, bei welcher die Sperrschicht zwischen den Schichten 1 und 14 die Schicht 193 erreicht. Diese Spannung kann durch Wahl des Abstandes a in Figur 1 auf einen gewünschten Wert eingestellt werden.

Der MOS-Transistor $F_V$ wird so bemessen, daß der Transistor die gewünschte Einschaltspannung erhält.

Die Öffnung in der Schicht 14 kann z. B. rechteckig sein und eine Größe von $100 \times 300$ μm haben. Die Schicht 192 kann dann eine Größe von ca. $50 \times 150$ μm haben, und der Abstand a kann 20 μm betragen. Die N-dotierte Schicht 1 kann eine Störstellenkonzentration von $10^{14}$ cm$^{-3}$ und die Schicht 193 kann eine Dotierungskonzentration von $10^{18} - 10^{19}$ cm$^{-3}$ haben.

Die Schichten 193—1—14 können als ein PNP-Verisator aufgefaßt werden, der in Figur 2 mit $V_V$ bezeichnet ist.

Die Steuerkreise für den Thyristor $T_H$ sind in Figur 1 an der unteren Seite der Siliziumscheibe angeordnet. Diese sind entsprechend aufgebaut wie die Steuerkreise für den Thyristor $T_V$, und sie sind in Fig. 1 entsprechend bezeichnet mit der Maßgabe, daß die »1« der ersten Ziffer der Bezugszahlen durch eine »2« ersetzt ist.

Bei der oben beschriebenen Ausführungsform der Erfindung ist die Schottky-Diode in einem gewissen Abstand von der kathodenseitigen Basisschicht 14 des Thyristors $T_V$ angeordnet, also von der Schicht, die an den von dem MOS-Transistor $F_V$ überbrückten PN-Übergang angrenzt. Alternativ kann die Schottky-Diode natürlich neben oder in einer Öffnung in einer separaten, P-leitenden Schicht angeordnet werden, die an die Basisschicht 14 oder die Kathode des Thyristors $T_V$ angeschlossen ist und die dadurch ein Potential erhält, das im wesentlichen mit dem Potential der Kathode übereinstimmt.

## Patentansprüche

1. Zweipoliger Überstromschutz zur Einschaltung in eine stromführende Leitung, welcher Überstromschutz einen im Normalbetrieb leitenden, löschbaren Thyristor ($T_V$) enthält, der der Reihe nach eine erste Emitterschicht (13), eine erste Basisschicht (14), eine zweite Basisschicht (1) und eine zweite Emitterschicht (21, 22) enthält, wobei parallel zu dem PN-Übergang zwischen der ersten Emitterschicht (13) und der ersten Basisschicht (14) des Thyristors ($T_V$) ein integrierter MOS-Transistor (Feldeffekttransistor) ($F_V$) angeordnet ist, welcher den PN-Übergang zum Löschen des Thyristors ($T_V$) kurzschließt, wenn die Spannung am Thyristor ($T_V$) einen bestimmten Wert übersteigt, dadurch gekennzeichnet,
daß der Steuereingang (17) des MOS-Transistors ($F_V$) über eine Schottky-Diode ($SD_V$) an die zweite Basisschicht (1) des Thyristors ($T_V$) angeschlossen ist,
daß die Sperrichtung der Schottky-Diode ($SD_V$) mit der Sperrichtung des Thyristors ($T_V$) zusammenfällt,
daß die Schottky-Diode ($SD_V$) aus dem Übergang zwischen der zweiten Basisschicht (1) und einer auf dieser angeordneten, mit dem Steuereingang (17) des MOS-Transistors ($F_V$) verbundenen Kontaktschicht (191, 192) besteht und
daß die Schottky-Diode ($SD_V$) getrennt neben einem Halbleiterbereich (14) angeordnet ist, welcher von gleicher Leitungsart wie die erste Basisschicht (14) ist und mit der ersten Emitterschicht (13) verbunden ist.

2. Überstromschutz nach Anspruch 1, dadurch gekennzeichnet, daß in der zweiten Basisschicht (1) ein ringförmiger Halbleiterbereich (193) von gleicher Leitungsart wie die erste Basisschicht (14) vorhanden ist, der an die Kontaktschicht (192) angrenzt und mit dieser in Kontakt steht.

3. Überstromschutz nach Anspruch 2, dadurch gekennzeichnet, daß der Abstand (a) zwischen dem ringförmigen Halbleiterbereich (193) und dem Halbleiterbereich (14), neben welchem die Schottky-Diode ($SD_V$) angeordnet ist, so bemessen ist, daß die Spannung zwischen diesen beiden Bereichen, bei der Strom zwischen den Bereichen zu fließen beginnt, kleiner als die Durchbruchspannung des Steuereingangs (17) des MOS-Transistors ($F_V$) ist.

## Claims

1. Two-pole overcurrent protection device for connecting into a current-carrying conductor, which overcurrent protection device includes an extinguishable thyristor ($T_V$) being conductive under normal operating conditions, and having successively a first emitter layer (13), a first base layer (14), a second base layer (1), and a second emitter layer (21, 22), and with an integrated MOS-transistor ($F_V$) (field effect transistor) connected in parallel to the PN-junction between the first emitter layer (13) and the first base layer (14) of the thyristor ($T_V$) said MOS-transistor ($F_V$) short-circuiting the PN-junction to extinguish the

thyristor ($T_V$) when the voltage across the thyristor ($T_V$) exceeds a predetermined value, characterized in that the control input (17) of the MOS-transistor ($F_V$) is connected to the second base layer (1) of the thyristor ($T_V$) via a Schottky diode ($SD_V$), that the blocking direction of the Schottky diode ($SD_V$) coincides with the blocking direction of the thyristor ($T_V$), that the Schottky diode ($SD_V$) consists of the junction between the second base layer (1) and a contact layer (191, 192) arranged on said second basis layer (1) and being connected with the control input (17) of the MOS-transistor ($F_V$), and that the Schottky diode ($SD_V$) is separately located adjacent a semiconductor area (14) being of the same conduction type as said first base layer (14) and being connected to said first emitter layer (13).

2. Overcurrent protection device according to claim 1, characterized in that said second base layer (1) comprises an annular semiconductor area (193) of the same conduction type as said first base layer (14), which borders on an makes contact with said contact layer (192).

3. Overcurrant protection device according to claim 2, characterized in that the distance (a) between said annular semiconductor area (193) and said semiconductor area (14), adjacent to which the Schottky diode ($SD_V$) is located, is dimensioned such that the voltage between these two areas, at which current begins to flow between said areas, is smaller that the breakdown voltage of the control input (17) of the MOS-transistor ($F_V$).

## Revendications

1. Dispositif de protection bipolaire contre les surintensités pour son insertion dans un conducteur traversé par un courant électrique, lequel dispositif de protection contre les surintensités comprend un thyristor ($T_V$) conducteur en fonctionnement, susceptible d'être amené dans son état de non conduction et comporte successivement une première couche d'émetteur (13), une première couche de base (14), une deuxième couche de base (1) et une deuxième couche d'émetteur (21, 22), un transistor MOS intégré (transistor à effet de champ) ($F_V$) étant disposé en parallèle sur la jonction PN, entre la première couche d'émetteur (13) et la première couche de base (14) du thyristor ($T_V$), et court-circuitant la jonction PN pour amener le thyristor ($T_V$) dans son état de non conduction lorsque la tension appliquée au thyristor ($T_V$) dépasse une valeur prédéterminée,
caractérisé par le fait,
que l'entrée de commande (17) du thyristor MOS ($F_V$) est reliée par l'intermédiaire d'une diode Schottky ($SD_V$) à la deuxième couche de base (1) du thyristor ($T_V$),
que la couche d'arrêt de la diode Schottky ($SD_V$) coïncide avec la direction inverse du thyristor ($T_V$), que la diode Schottky ($SD_V$) est constituée par la jonction entre la deuxième couche de base (2) et une couche de contact (191, 192) disposée sur cette deuxième couche de base (1) et reliée à l'entrée de commande (17) du transistor MOS (F$_V$), et

que la diode Schottky (SD$_V$) est disposées près d'une zone semiconductrice (14) qui a le même type de conductibilité que la première couche de base (14) et que est reliée à la première couche d'émetteur (13).

2. Dispositif de protection contre le surintensités selon la revendication 1, caractérisé par le fait qu'il est prévu dans la deuxième couche de base (1) une zone semiconductrice annulaire (193) possédant le même type de conductibilité que la première couche de base (14), jouxtant la couche de contact (192) et en contact avec celle-ci.

3. Dispositif de protection contre les surintensités selon la revendication 2, caractérisé par le fait que la distance (a) entre la zone semiconductrice annulaire (193) et la zone semiconductrice (14) près de laquelle est disposée la diode-Schottky (SD$_V$) est dimensionnée de telle façon que la tension entre ces deux zones pour laquelle le courant commence à passer dans celle-ci, est plus faible que la tension de rupture de l'entrée de commande (17) du transistor MOS (F$_V$).

# FIG. 1

FIG. 2